## Europäisches Patentamt

## European Patent Office

## Office européen des brevets

(11) Publication number: **0 053 481**
**B1**

(12) **EUROPEAN PATENT SPECIFICATION**

(45) Date of publication of patent specification: **11.11.87**

(21) Application number: **81305589.4**

(22) Date of filing: **26.11.81**

(51) Int. Cl.⁴: **C 30 B 1/02,** C 30 B 29/26,
C 30 B 29/30, C 30 B 29/28

(54) **Method for producing a single crystal.**

(30) Priority: **28.11.80 JP 166645/80**

(43) Date of publication of application:
**09.06.82 Bulletin 82/23**

(45) Publication of the grant of the patent:
**11.11.87 Bulletin 87/46**

(84) Designated Contracting States:
**DE FR GB NL**

(56) References cited:
**EP-A-0 039 593**
**FR-A-1 328 946**
**FR-A-2 212 177**
**FR-A-2 457 193**
**GB-A-2 054 405**
**JP-A-55 162 496**
**US-A-3 278 273**
**US-A-3 849 205**

The file contains technical information
submitted after the application was filed and
not included in this specification

(73) Proprietor: **NGK INSULATORS, LTD.**
**2-56, Suda-cho, Mizuho-ku**
**Nagoya-shi, Aichi 467 (JP)**

(72) Inventor: **Matsuzawa, Soichiro**
**1000-13, Aza-Shinden Ohaza-Rengeji**
**Kuwana City (JP)**
Inventor: **Mase, Syunzo**
**435, Aza-Motokinogo Ohaza-Tobishima-shinden**
**Tobishima-Mura Ama-Gun Aichi Pref (JP)**

(74) Representative: **Paget, Hugh Charles Edward**
**et al**
**MEWBURN ELLIS & CO. 2/3 Cursitor Street**
**London EC4A 1BQ (GB)**

(56) References cited:
**ZEITSCHRIFT FÜR ANGEWANDTE PHYSIK, vol.**
**21, no. 1, 1966 (DE), M. PAULUS et al.**
**"Croissance de monocristaux de BaFe12019 à**
**l'Etat solide", pages 39-45**

Courier Press, Leamington Spa, England.

## Description

The present invention relates to a method for producing a single crystal by a solid phase reaction involving a polycrystal exhibiting discontinuous crystal grain growth.

Methods are known for producing a single crystal wherein a starting material is melted at a temperature higher than the melting point of the starting material and a single crystal is grown from the molten liquid phase; examples of such methods are the pickup process, Bernoulli process, Bridgman process, floating zone melting process, and flux process.

However, any conventional method wherein a single crystal is grown from a molten liquid phase needs a high temperature, so that when a starting material containing a component having a high vapor pressure is used, the composition easily varies and impurities are readily taken up from a crucible used for melting the starting materials, so that the crystallinity of the obtained single crystal obtained is not uniform. Furthermore, all the above described conventional methods need a large, expensive and complicated production apparatus and the production conditions are severe, so that mass production is difficult and the single crystal product is only obtained at a high cost.

The present invention is set out in claim 1.

In the method of invention a single crystal is grown by forming a body having a nucleus for growth which is a macrocrystal grain in or on a polycrystal and growing the nucleus into a polycrystal by a solid phase reaction.

The present invention will be explained and illustrated in more detail below.

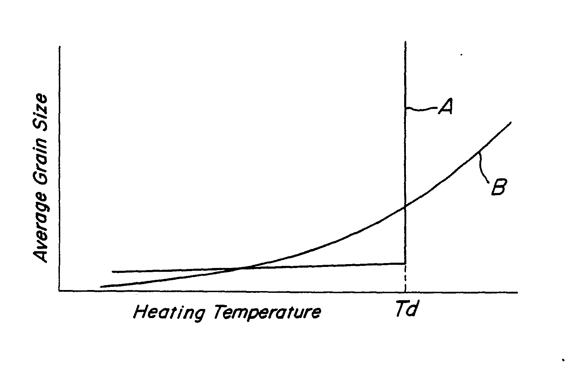

In the following description reference will be made to the accompanying drawing, which is a graph showing the relation of the heating temperature to the average grain size of polycrystals.

When a polycrystal composed of microcrystal grains is heated at a temperature lower than its melting point, the crystal grains comprising the polycrystal grow. When such a polycrystal exhibits discontinuous crystal grain growth as shown by curve A in the accompanying drawing, the crystal grains grow only very slightly when the heating temperature is lower than a particular temperature Td°C. When the temperature becomes Td°C or higher a part of the crystal grains suddenly integrate with the surrounding microcrystal grains and rapidly grow into macrocrystal grains. On the other hand when a polycrystal exhibits continuous crystal grain growth as shown by a curve B in the drawing, as the heating temperature is raised the crystal grains grow continuously even up to a high temperature.

The present invention relates to a method for producing a single crystal using a polycrystal exhibiting discontinuous crystal grain growth at a particular temperature Td°C as shown by the curve A.

The term "discontinuous crystal grain growth" used herein means the phenomenon that nuclei which form starting points of the discontinuous crystal grain growth in a polycrystal at a particular temperature, that is a crystal grain having a size which is for example several tens times the size of the surrounding crystal grains, are formed. The nuclei then grow by integrating with the surrounding microcrystal grains at a rapid rate. The term "temperature causing discontinuous crystal grain growth" used herein means the temperature causing such a phenonenon. The phase where the nuclei of the discontinuous crystal grain growth of the polycrystal are formed and the phase when the nuclei grow are entirely different and the temperatures at which the respective phases occur are different.

That is to say, in a polycrystal exhibiting discontinuous crystal grain growth during the phase of heating, the temperature at which the nuclei of the discontinuous crystal grain growth are formed is higher than the temperature at which the nuclei grow. When a nucleus which becomes the starting point of the discontinuous crystal grain growth, has been previously formed in a polycrystal and then heating is effected at a temperature lower than the temperature at which the discontinuous crystal grain growth of the polycrystal occurs, only the macrocrystal grain which has been previously formed as the nucleus can be greatly grown at a rapid rate.

Accordingly, the method of the present invention for producing a single crystal comprises first forming a body having a macrocrystal grain as a nucleus for discontinuous crystal grain growth in a polycrystal exhibiting discontinuous crystal grain growth or forming such a macrocrystal grain after preparing the polycrystal and then heating the body at a temperature at which the discontinuous crystal grain growth of the polycrystal occurs in such a manner as to grow only the macrocrystal grain at a fairly high rate.

Therefore in the present invention it is very important that a macrocrystal grain having substantially the same crystal structure as the crystal grains comprising the polycrystal, and having a size from several times, generally several tens times, the size of the crystal grains comprising the polycrystal, are formed prior to heating the composite body according to step (b) of claim 1.

The formation of the composite body comprising the macrocrystal grain in or on a polycrystal may be carried out by the following processes.

A small piece of single crystal which is a macrocrystal grain is first embedded in a shaped body of precursor material for the polycrystal or a small piece of such a single crystal is contacted with a surface of a shaped body of precursor material for the polycrystal and the shaped body and the single crystal are concurrently integrally sintered to form the composite body.

A small portion of the polycrystal may be heated at a temperature higher than the temperature causing the discontinuous crystal grain growth of the polycrystal with for example a laser beam or electron rays to grow a macrocrystal grain locally.

A polycrystal having a conical shape at an extremity may be used. Such a polycrystal is heated to form a macrocrystal grain at the projection due to the large surface tension possessed by the projection. Alternatively stress is locally applied during heating to form a macrocrystal grain at a portion where the stress is concentrated.

A substance having substantially the same composition as the composition comprising a polycrystal may be applied to at least one portion of the polycrystal surface by spattering, vapour deposition, CVD or an equivalent process to form an amorphous or microcrystal film. This film is then locally heated by for example electron rays or infrared rays, or if necessary an electron beam is scanned on the film surface, to form a macrocrystal from the local portion, or a stress is locally applied to a portion of the film to form a macrocrystal grain. Alternatively, a small piece of a seed single crystal may be contacted with the amorphous film or microcrystal film and heated to form a single crystal film having the same crystal orientation as the seed single crystal.

The processes usable for forming the macrocrystal grain in or on the polycrystal are not limited to the above described processes and other processes may be employed.

The heating temperature for growing the single crystal by growing the macrocrystal grain used as the nucleus in the polycrystal direction is preferably a temperature as near as possible to the temperature at which the discontinuous crystal grain growth of the polycrystal occurs, preferably a temperature which is within 100°C lower, particularly within 50°C lower, than the temperature causing the discontinuous crystal grain growth of the polycrystal.

The present invention is applicable to the production of single crystals of various oxides, such as ferrite, garnet, spinel, niobates, tantalates and titanates, metals, carbides, and nitrides. For example, the heating temperature for producing a manganese zinc ferrite single crystal is preferably 1,250—1,450°C, the heating temperature for producing a nickel zinc ferrite single crystal is preferably 1,250—1,550°C, and the heating temperatures for producing garnet and spinel single crystals are preferably 1,300—1,450°C and 1,700—1,900°C respectively. However, the average grain size and porosity of the polycrystals vary depending upon the condition for producing each polycrystal, for example the purity or composition of the starting materials, firing temperature and firing atmosphere, and the temperature causing the discontinuous crystal grain growth varies depending upon these effects, so that the heating temperature is selected within the above described temperature range depending upon the purity, composition, average grain size and porosity of the starting materials. The same considerations apply to niobates and tantalates, and the heating temperature suitable for growing a single crystal may be confirmed by a heating test.

In the process for growing a single crystal, the whole polycrystal may be held at a constant temperature lower than the temperature causing the discontinuous crystal grain growth.

However since the temperature causing the discontinuous crystal grain growth of the polycrystal rises with the passage of time while the material is held at high temperature, the heating temperature is generally gradually raised at a temperature increase rate of about 5 to 100°C/hr, preferably 10 to 50°/hr, while keeping below the temperature causing the discontinuous grain growth at the relevant time.

To prevent crystal growth at portions other than the boundary surface between the single crystal and the polycrystal the single crystal side should be at a higher temperature and the polycrystal side at a lower temperature, so that the higher temperature portion transfers in turn to the polycrystal side to convert the whole into a single crystal.

In order to obtain polycrystals exhibiting discontinuous crystal grain growth at high temperature, for example in the case of ferrite polycrystal and garnet polycrystal, iron oxide ($Fe_2O_3$) having a purity of higher than 99.9% obtained by roasting magnetite may be used. In the production of spinel polycrystal, alumina ($Al_2O_3$) having a purity of higher than 99.9% may be used. As regards niobates and tantalates, niobium oxide and tantalum oxide having high purity may be similarly used.

The invention will be further illustrated by the following Examples.

Example 1

A mixture having a composition of 50 mol% of $LiO_2$ and 50 mol% of $Nb_2O_5$ was prepared by using lithium oxide having a purity of 99.9% and niobium oxide having a purity of 99.9% as starting materials, the mixture was formed into shaped body, a 1 mm cubic $LiNbO_3$ single crystal was embedded in substantially the centre of the shaped body and a shaped body of dimensions 15×15×15 mm was prepared. This shaped body was fired at 1,100°C for 2 hours to obtain composite body having a polycrystal of $LiNbO_3$ including a macrocrystal grain.

This polycrystal had an average grain size of 5 μm and a porosity of 0.02%. As a result of a heating test, the temperature causing the discontinuous crystal grain growth was found to be 1,210°C. The surface portion of the polycrystal was removed to prepare a block of dimensions 10×10×10 mm and this block was heated at 1,150°C in air and then the temperature was raised from 1,150°C to 1,205°C at a temperature increase rate of 10°C/hr and then the block was cooled to obtain a $LiNbO_3$ single crystal of dimensions 10×10×10 mm.

Example 2

A mixture having a composition of 31 mol% of MnO, 16.5 mol% of ZnO and 52.5 mol% of $Fe_2O_3$ and containing less than 0.01% of $SiO_2$, less than 0.05% of $TiO_2$, less than 0.005% of CaO and less than 0.03% of $Na_2O$ as impurities was prepared by using manganese oxide having a purity of 99.9% obtained by roasting manganese carbonate, zinc oxide having a purity of 99.9%, and ferric oxide obtained by roasting magnetite as starting materials, and the mixture was formed into a shaped body and the shaped body was roasted at 1,320°C for 4 hours under equilibrium oxygen partial pressure to obtain a manganese zinc ferrite polycrystal.

This ferrite polycrystal had an average grain size of about 7 μm and a porosity of about 0.01%. In order to confirm the temperature causing the discontinuous crystal grain growth of the ferrite polycrystal, a heating test was effected and the variation of the crystal grains comprising the polycrystal with respect to the heating temperature was determined. When a temperature of 1,350°C was held for one hour the grain size was 8 μm, at 1,370°C the grain size was 9 μm, at 1,380°C some macrocrystal grains having a grain size of 50—200 μm were observed among the crystal grains having an average crystal grain size of 9 μm, and at 1,390°C the whole polycrystal was composed of macrocrystal grains of 3—5 mm; the temperature causing the discontinuous crystal grain growth was therefore 1,380°C.

A block of dimensions 5×5×5 mm was cut-off from this manganese zinc ferrite polycrystal and this block was locally heated in a nitrogen atmosphere by using a laser beam at a focus temperature of 1,400°C to form at the heating location a macrocrystal grain having a grain size of about 200 μm. This block was heated from 1,150°C to 1,350°C at a temperature raising rate of 300°C/hr under a nitrogen atmosphere having an oxygen concentration of 5 vol% and then the temperature was raised to 1,420°C at a temperature raising rate of 30°C/hr and then the block was cooled to obtain a manganese zinc ferrite single crystal of dimensions 5×5×5 mm.

Example 3

A ferrite mixture having a composition of 31 mol% of MnO, 16.5 mol% of ZnO and 52.5 mol% of $Fe_2O_3$ and containing less than 0.01% of $SiO_2$, less than 0.05% of $TiO_2$, less than 0.005% of CaO and less than 0.03% of $Na_2O$ as impurities was prepared by using manganese oxide having a purity of 99.9% obtained by roasting manganese carbonate, zinc oxide having a purity of 99.9%, and ferric oxide obtained by roasting magnetite as starting materials, and the mixture was shaped and the shaped body was fired at 1,320°C for 4 hours under equilibrium oxygen partial pressure to obtain a manganese zinc ferrite polycrystal.

This ferrite polycrystal had an average grain size of about 10 μm and a porosity of about 0.01% and the temperature causing the discontinuous crystal grain growth was 1,380°C. From this ferrite polycrystal a circular rod of 5φ×20 mm was cut off and one end of the rod was formed into a conical shape having an angle of 60°. Then the rod was heated from 1,150°C to 1,350°C at a temperature increase rate of 300°C/hr under a nitrogen atmosphere having an oxygen concentration of 5 vol% and the temperature was further raised to 1,420°C at a temperature increase rate of 30°C/hr to obtain a manganese zinc ferrite single crystal of dimensions 5φ×20 mm.

Example 4

A mixture having a composition of 37.5 mol% of $Y_2O_3$ and 62.5 mol% of $Fe_2O_3$ and containing less than 0.01% of $SiO_2$, less than 0.005% of CaO and less than 0.0003% of $Na_2O$ as impurities was prepared by using yttrium oxide having a purity of 99.9% and ferric oxide having a purity of 99.9% as starting materials, and the mixture was shaped and fired at 1,370°C for 6 hours to obtain a yttrium iron garnet polycrystal.

This polycrystal had an average grain size of about 15 μm and a porosity of 0.05% and the temperature causing the discontinuous crystal grain growth was 1,420°C. From this yttrium iron garnet polycrystal a circular rod of dimensions 5φ×20 mm was cut-off, and one end of the rod was formed into a conical shape having an angle of about 60°. Then this rod was heated from 1,200°C to 1,370°C at a temperature increase rate of 300°C/hr and then the temperature was further raised to 1,450°C at a temperature increase rate of 30°C/hr and then the heated rod was cooled to obtain a yttrium iron garnet single crystal of dimensions 5φ×20 mm.

Example 5

A mixture having a composition of 50 mol% of MgO and 50 mol% of $Al_2O_3$ was prepared by using magnesium oxide having a purity of 99.9% and aluminium oxide having a purity of 99.9% and containing less than 0.005% of $SiO_2$, 0.005% of $TiO_2$ and less than 0.003% of CaO as impurities as starting material, and the mixture was shaped and fired at 1,700°C for 5 hours in a hydrogen atmosphere to obtain a spinel polycrystal.

This spinel polycrystal had an average grain size of about 7 μm and a porosity of 0.2% and the temperature causing the discontinuous crystal grain growth was 1,800°C. From this spinel polycrystal there was cut-off a circular rod of dimensions 5φ×20 mm and one end of the rod was formed into a conical shape having an angle of 60°. The rod was heated to 1,700°C at a temperature increase rate of 300°C/hr in a hydrogen atmosphere and the temperature was further raised to 1,850°C at a temperature increase rate of 30°C/hr and then the heated rod was cooled to obtain a spinel single crystal of dimensions 5φ×20 mm.

Example 6

A mixture having a composition of 31 mol% of MnO, 16.5 mol% of ZnO and 52.5 mol% of $Fe_2O_3$ and containing less than 0.01% of $SiO_2$, less than 0.05% of $TiO_2$, less than 0.005% of CaO and less than 0.03% of $Na_2O$ as impurities was prepared by using manganese oxide having a purity of 99.9% obtained by roasting manganese carbonate, zinc oxide having a purity of 99.9%, and ferric oxide having a purity of 99.9% obtained by roasting magnetite as starting materials, and the mixture was shaped and fired at 1,320°C for 4 hours under equilibrium oxygen partial pressure to obtain a manganese zinc ferrite polycrystal.

The ferrite polycrystal had an average grain size of 10 μm and a porosity of 0.01% and the temperature causing the discontinuous crystal grain growth was 1,380°C. From this manganese zinc ferrite polycrystal a block of dimensions 10×10×5 mm was cut-off and on one side surface of the block was formed a manganese zinc ferrite amorphous film through high frequency spattering. One end of the amorphous film was locally heated at 1,000°C by a laser beam to cause crystallization and then the laser beam was scanned spirally toward the outer circumference concentrically about the crystallized portion centre to obtain a single crystal film. This composite body of the single crystal and the polycrystal was heated from 1,150°C to 1,350°C at a temperature increase rate of 300°C/hr in a nitrogen atmosphere having an oxygen concentration of 5 vol% and the temperature was further raised to 1,420°C at a temperature increase rate of 30°C/hr followed by cooling to obtain a manganese zinc ferrite single crystal of dimensions 10×10×5 mm.

Example 7

A mixture having a composition of 31 mol% of MnO, 16.5 mol% of ZnO and 52.5 mol% of Fe$_2$O$_3$ and containing less than 0.01% of SiO$_2$, less than 0.05% of TiO$_2$, less than 0.005% of CaO and less than 0.03% of Na$_2$O as impurities was prepared by using manganese oxide having a purity of 99.9% obtained by roasting manganese carbonate, zinc oxide having a purity of 99.9%, and ferric oxide obtained by roasting magnetite as starting materials, and the mixture was shaped and fired at 1,250°C for 6 hours under equilibrium oxygen partial pressure to obtain a manganese zinc ferrite polycrystal.

This ferrite polycrystal had an average grain size about 3 μm and a porosity of about 0.01% and the temperature causing the discontinuous crystal grain growth was 1,350°C. From this ferrite polycrystal there was cut off a block of dimensions 50×50×5 mm and one side surface of the block was polished to a mirror surface and on this surface was formed a 1 μm manganese zinc ferrite amorphous film through high frequency spattering and on the film was mounted a single crystal of dimensions 3×3×1 mm produced by a high pressure Bridgman process. This was heated at 900°C in a nitrogen atmosphere to convert the amorphous film into a single crystal along the crystal orientation of the single crystal. Then, the composite body of the single crystal and the polycrystal was heated from 1,150°C to 1,320°C at a temperature increase rate of 300°C/hr in a nitrogen atmosphere having an oxygen concentration of 5 vol% and the temperature was further raised to 1,370°C at a temperature increase rate of 30°C/hr followed by cooling to obtain a manganese zinc ferrite single crystal of dimensions 50×50×5 mm.

Example 8

A mixture having a composition of 37.5 mol% of Y$_2$O$_3$ and 62.5 mol% of Fe$_2$O$_3$ and containing less than 0.01% of SiO$_2$, less than 0.005% of CaO and less than 0.003% of Na$_2$O as impurities was prepared by using yttrium oxide having a purity of 99.9% and ferric oxide having a purity of 99.9% obtained by roasting magnetite as starting materials, and the mixture was shaped and fired at 1,370°C for 6 hours to obtain an yttrium iron garnet polycrystal.

This polycrystal had an average grain size of about 15 μm and a porosity of 0.05% and the temperature causing the discontinuous crystal grain growth was 1,420°C. From this yttrium iron garnet polycrystal a block of dimensions 10×10×5 mm was cut-off and on the block surface was formed a 5 μm yttrium iron garnet microcrystal film by a CVD process. Infrared rays from a halogen lamp were collected by a concave reflection mirror in air and focussed on one end of the film to locally heat the film at a focus temperature of 1,000°C, and then the whole film was heated at 900°C to obtain a single crystal film.

This composite body of the single crystal film and the polycrystal was heated from 1,200°C to 1,370°C at a temperature increase rate of 300°C/hr in air and this temperature was further raised to 1,450°C at a temperature increase rate of 30°C/hr followed by cooling to obtain an yttrium iron garnet single crystal of dimensions 10×10×5 mm.

Example 9

A mixture having a composition of 50 mol% of MgO and 50 mol% of Al$_2$O$_3$ was prepared by using magnesium oxide having a purity of 99.9% and aluminium oxide having a purity of 99.9% and containing less than 0.005% of SiO$_2$, less than 0.005% of TiO$_2$ and less than 0.003% of CaO as impurities as starting materials. The mixture was shaped and fired at 1,700°C for 5 hours in a hydrogen atmosphere to obtain a spinel polycrystal.

This spinel polycrystal had an average grain size of about 7 μm and a porosity of 0.2% and the temperature causing the discontinuous crystal grain growth was 1,800°C. From this spinel polycrystal a block of dimensions 5×5×2 mm was cut-off and on the surface thereof there was formed a 5 μm spinel amorphous film at an oxygen partial pressure of 1×10$^{-4}$ torr and at a temperature of 500°C through high frequency spattering. A part of the amorphous film was locally heated at 1,600°C by a laser beam to cause crystallization and then the whole amorphous film was heated at 1,500°C to obtain a single crystal film. This composite body of the single crystal film and the polycrystal was heated to 1,700°C in a hydrogen atmosphere at a temperature increase rate of 300°C/hr and the temperature was further raised to 1,850°C at a temperature increase rate of 30°C/hr followed by cooling to obtain a spinel single crystal of dimensions 5×5×2 mm.

The method of the present invention can be effected at a lower temperature than a conventional method for producing a single crystal from a liquid phase, so that unbalance of the composition due to evaporation does not occur, and also an apparatus for producing a single crystal which is large, complicated and expensive is not necessary. The single crystal can thus be commercially produced cheaply by a very simple process, such as a conventional sintering process. The present invention can be applied to the production of ceramics and metal single crystals.

## Claims

1. A method of producing a single crystal comprising

(a) providing a composite body having a macrocrystal in contact with a polycrystal which has substantially the same crystal structure as the macrocrystal and exhibits discontinuous crystal grain growth, by forming at least one of said macrocrystal and said polycrystal from precursor material which during this forming is in contact with the other of said macrocrystal and said polycrystal or the precursor material therefor,

(b) heating said composite body while keeping the temperature lower than the temperature causing discontinuous crystal grain growth of the polycrystal so that the macrocrystal acts as a nucleus for grain growth thereby to integrate the polycrystal grains with the macrocrystal, thereby to grow a single crystal.

2. A method as claimed in claim 1 wherein the polycrystal is formed by sintering the precursor material therefore in contact with the macrocrystal.

3. A method as claimed in claim 1, wherein the macrocrystal is formed in contact with the polycrystal by locally heating the polycrystal at a temperature higher than the temperature causing the discontinuous crystal grain growth to form the macrocrystal.

4. A method as claimed in claim 1, wherein the macrocrystal is formed in contact with the polycrystal by forming a pointed portion of the polycrystal and heating the said pointed portion to form the macrocrystal.

5. A method as claimed in claim 1, wherein the macrocrystal is formed in contact with the polycrystal by heating the polycrystal and concurrently locally applying a stress to the polycrystal to form the macrocrystal.

6. A method as claimed in claim 1, wherein the macrocrystal is formed in contact with the polycrystal by forming an amorphous film or microcrystal film on at least a part of the polycrystal surface and heating the said film or applying stress to the film to form the macrocrystal.

7. A method as claimed in claim 6 wherein an amorphous film or microcrystal film is heated in contact with a seed single crystal to form the macrocrystal integrated with the seed single crystal.

## Patentansprüche

1. Verfahren zur Herstellung eines Einkristalls durch

(a) Schaffen eines Verbundkörpers, der einen Makrokristall in Kontakt mit einem Polykristall aufweist, der im wesentlichen die gleiche Kristallstruktur hat wie der Makrokristall und ein diskontinuierliches Kristallkornwachstum zeigt, indem man mindenstens einen von dem genannten Makrokristall und dem genannten Polykristall aus Vorläufermaterial bildet, das sich während der Bildung in Kontakt mit dem anderen des genannten Makrokristalls und des genannten Polykristalls oder des Vorläufermaterials dafür befindet,

(b) Erhitzen dieses Verbundkörpers, wobei man die Temperatur unterhalb des Temperatur hält, die das diskontinuierliche Kristallkornwachstum des Polykristalls verursacht, so daß der Makrokristall als ein Kern für das Kornwachstum wirkt, dadurch die Polykristallkörner mit dem Makrokristall integriert und dadurch zum Wachsen eines Einkristalls führt.

2. Verfahren nach Anspruch 1, wobei der Polykristall durch Sintern des Vorläufermaterials dafür in Kontakt mit dem Makrokristall gebildet wird.

3. Verfahren nach Anspruch 1, worin der Makrokristall in Kontakt mit dem Polykristall gebildet wird, indem man den Polykristall lokal auf eine Temperatur erhitzt, die höher ist als die Temperatur, die das diskontinuierliche Kristallkornwachstum verursacht, um den Makrokristall zu bilden.

4. Verfahren nach Anspruch 1, worin der Makrokristall in Kontakt mit dem Polykristall gebildet wird, indem man einen zugespitzten Abschnitt des Polykristalls bildet und diesen unter Bildung des Makrokristalls erhitzt.

5. Verfahren nach Anspruch 1, worin der Makrokristall in Kontakt mit dem Polykristall gebildet wird, indem man den Polykristall erhitzt und gleichzeitig lokal eine Spannung auf den Polykristall ausübt, um den Makrokristall zu bilden.

6. Verfahren nach Anspruch 1, worin der Makrokristall in Kontakt mit dem Polykristall gebildet wird, indem man einen amorphen oder mikrokristallinen Film auf mindestens einem Teil der Polykristalloberfläche bildet und den Film erhitzt oder Spannung auf den Film ausübt, um den Makrokristall zu bilden.

7. Verfahren nach Anspruch 6, worin ein amorpher Film oder ein mikrokristalliner Film in Kontakt mit einem Einkristallkeim erhitzt wird, um den Makrokristall integriert mit dem Einkristallkeim zu bilden.

## Revendications

1. Méthode de fabrication d'un momocristal consistant à

(a) prévoir un corps composite ayant un macrocristal en contact avec un polycristal qui a sensiblement la même structure cristalline que le macrocristal et qui présente une croissance discontinue du grain de cristal, en formant au moins l'un dudit macrocristal ou dudit polycristal à partir d'un matériau précurseur qui, pendant cette formation, est en contact avec l'autre dudit macrocristal ou dudit polycristal ou son matériau précurseur,

(b) chauffer ledit corps composite tout en maintenant la température plus faible que la température provoquant une croissance discontinue du grain de cristal du polycristal de manière que le macrocristal serve de noyau pour la croissance du grain afin d'intégrer ainsi les grains de polycristal au macrocristal, pour ainsi faire croître un monocristal.

2. Méthode selon la revendication 1 où le polycristal est formé par frittage de son matériau précurseur en contact avec le macrocristal.

3. Méthode selon la revendication 1 où le macrocristal est formé en contact avec le polycristal en chauffant localement le polycristal à une température supérieure à la température provoquant la croissance discontinue du grain du cristal pour former le macrocristal.

4. Méthode selon la revendication 1 où le macrocristal est formé en contact avec le polycristal en formant une portion pointue du polycristal et en chauffant ladite portion pointue pour former le macrocristal.

5. Méthode selon la revendication 1 où le macrocristal est formé en contact avec le polycristal par chauffage du polycristal et application concurrent et localement d'un effort au polycristal pour former le macrocristal.

6. Méthode selon la revendication 1 où le macrocristal est formé en contact avec le polycristal en formant un film amorphe ou film microcristallin sur au moins une partie de la surface du polycristal et en chauffant le même film ou en appliquant un effort au film pour former le macrocristal.

7. Méthode selon la revendication 6 où un film amorphe ou film microcristallin est chauffé en contact avec un monocristal d'ensemencement pour former le macrocristal intégré au monocristal d'ensemencement.